# EUROPÄISCHE PATENTSCHRIFT

(11) **EP 1 586 128 B1**
(45) Veröffentlichungstag und Bekanntmachung des Hinweises auf die Patenterteilung: **31.07.2019**
(21) Anmeldenummer: 04703392.3
(22) Anmeldetag: 20.01.2004
(51) Int. Cl.: H01L 51/54

(54) **KATHODE FÜR EIN ORGANISCHES ELEKTRONIKBAUTEIL**
CATHODE FOR AN ORGANIC ELECTRONICS COMPONENT
CATHODE POUR ELEMENT ELECTRONIQUE ORGANIQUE

(30) Priorität: 21.01.2003 DE 10302143
(43) Veröffentlichungstag der Anmeldung: 19.10.2005
(73) Patentinhaber: OSRAM OLED GmbH, 93049 Regensburg (DE)
(72) Erfinder: BIRNSTOCK, Jan, 01187 Dresden (DE); HENSELER, Debora, 91052 Erlangen (DE); HEUSER, Karsten, 91056 Erlangen (DE); PÄTZOLD, Ralph, 91154 Roth (DE); WITTMANN, Georg, 91074 Herzogenaurach (DE)
(74) Vertreter: Epping - Hermann - Fischer
(86) Internationale Anmeldenummer: PCT/EP2004/000427
(87) Internationale Veröffentlichungsnummer: WO 2004/066332

(56) Entgegenhaltungen:
- WO-A-02/052660
- US-A- 6 099 980
- US-A1- 2002 051 893
- PATENT ABSTRACTS OF JAPAN Bd. 1996, Nr. 02, 29. Februar 1996 (1996-02-29) & JP 7 288185 A (DAINIPPON PRINTING CO LTD), 31. Oktober 1995 (1995-10-31)

## Beschreibung

Die Erfindung betrifft eine neuartige metallische Kathodenschicht für ein Elektronikbauteil, insbesondere für eine Organische Leuchtdiode (OLED) sowie ein Herstellungsverfahren dazu.

Bekannt sind Kathoden für OLEDs, die in der Regel einen zweischichtigen Stapel umfassen. Die erste Schicht ist in der Regel aus zwei Arten von Materialien ausgewählt: Entweder ist sie aus eher reaktiven Metallen wie Barium oder Calcium oder aus isolierenden Stoffen wie Caesiumfluorid oder Lithiumflourid. Die zweite Schicht ist typischerweise aus eher mehr oder weniger edlen Metallen gemacht wie Silber oder Aluminium und dient als Elektrodenbahn und zur Abschottung der inneren Schichten gegen oxidierende Gase. Die beiden Schichten werden herkömmlich unter Bedingungen hergestellt, die Wasser- und Sauerstoffpartialdrücke von unter 10⁻⁹ bar zeigen, sogenannte "ultra-vacuum" Bedingungen. Diese Bedingungen können einmal über eine reale Ultra-Hoch-Vakuum Pumpe erzeugt werden und zum anderen über eine Inertgasatmosphäre mit Drücken kleiner 10⁻⁶ bar, wobei diese Inertgasdrücke dann Wasser- und Sauerstoffpartialdrücke unter der Grenze haben, die dem OLED Aufbau schadet. Beide Herstellungsprozesse sind offensichtlich sehr kostspielig und wenig effizient.

Die Druckschrift WO 02/052660 A1 betrifft eine OLED und ein Herstellungsverfahren hierfür.

Aus der Druckschrift US 2002/0051893 A1 sind Materialien für Kathodenkontakte für Leuchtdioden mit hohen Leuchtdichten bekannt.

In der Druckschrift JP H07-288185 A findet sich eine Dünnfilm-OLED.

Eine OLED ist in der Druckschrift US 6 099 980 A offenbart.

Aufgabe der vorliegenden Erfindung ist es, eine Kathode für ein Elektronikbauteil, insbesondere für eine organische Leuchtdiode zu schaffen, die ohne ultra-vacuum Bedingungen herstellbar ist.

Gegenstand der Erfindung ist eine Kathode für ein organisches Elektronikbauteil gemäß Anspruch 1. Diese Kathode ist im wesentlichen aus einer Schmelze einer metallischen Legierung gefertigt. Außerdem ist Gegenstand der Erfindung ein Verfahren zur Herstellung einer solchen Kathode für eine OLED durch Aufbringen der Schmelze einer metallischen Legierung.

Mit "im wesentlichen" aus einer metallischen Legierung ist gemeint, dass der Legierung noch (übliche) Additive, wie Benetzungsmittel, Haftvermittler oder ähnliches zugesetzt sein können.

Wegen des hohen Schmelzpunktes der Metalle oder typischen Legierungen (weit über 200 °C) können andere Aufbringungstechniken als physical vapour deposition (PVD) zur Herstellung der Kathode nicht eingesetzt werden, weil Temperaturen oberhalb ungefähr 130 bis 150 °C (abhängig vom Polymer) das Emittermaterial signifikant schädigen. Jedoch gibt es eine Klasse metallischer Legierungen, die sogenannten "fusible alloys", die sich durch niedrige Schmelzpunkte im Bereich zwischen 30 °C und 200 °C auszeichnen. Typischerweise ist dabei der Schmelzpunkt der Legierung niedriger als der des zugrunde liegenden Metalls. Diese metallischen Legierungen erlauben daher eine Kathodenherstellung aus der Schmelze bei Temperaturen, die ein Emittermaterial noch vertragen kann. Es gibt eine ganze Reihe kommerziell im Handel erhältlicher fusible alloys, die alle zur Kathodenherstellung eingesetzt werden können.

Bevorzugt ist die metallische Legierung zur Herstellung der Kathode oxidationsunempfindlich, insbesondere auch oberhalb ihrer Schmelztemperatur, so dass die Herstellung durch Aufbringen der Schmelze nicht einmal eine Schutzgasatmosphäre erfordert.

Die Schmelze wird, bevorzugt strukturiert, durch einen Druckprozess, wie Stempel- oder Tampondruck, Siebdruck, Tintenstrahldruck, Hoch- und/oder Tiefdruck, Schablonendruck, Flexodruck und sonstige aufgebracht.

Die
Legierung des "fusible alloys" kann auch mittels einer Prägetechnik oder wie ein Gießharz aufgebracht werden. Ebenso gut kann die Schmelze auch unstrukturiert durch Spin Coating, Eintauchen, Rakelverfahren etc. aufgebracht und sogar in einem späteren Produktionsschritt strukturiert werden.

Die "fusible alloys" sind ihrer Art nach bekannt, es handelt sich beispielweise um Legierungen, die ein "Eutektikum" bilden, das heißt bei einer bestimmten prozentualen Mol-, Gewichts- oder Volumenverteilung der Komponenten in der Legierung sinkt der Schmelzpunkt der Legierung oder Mischung weit unter den der Einzelkomponenten. Die eutektischen Legierungen haben außerdem den Vorteil, dass sie einen definierten Schmelzpunkt haben im Gegensatz zu einem Schmelzbereich, der sich unter Umständen über 10 °C oder mehr erstrecken kann.

Bevorzugt handelt es sich um eine Legierung, die im Bereich zwischen 30 °C und 200 °C, insbesondere bevorzugt unterhalb von 150 °C, als Schmelze vorliegen kann.

Bestandteile dieser Legierungen sind erfindungsgemäß die folgenden Metalle sein: Wismut, Zinn, Indium, wobei das "fusible alloy" sich dadurch auszeichnet, dass sein Schmelzpunkt deutlich, also messbar in Grad Celsius, unter dem der Einzelbestandteile liegt.

Besonders vorteilhaft sind die gesundheitlich unbedenklichen "fusbile alloys" oder Legierungen, also die, die mit wenig oder ohne Cadmium, Quecksilber und/oder Blei auskommen.

Erfindungsgemäß werden folgende Legierungen herangezogen: 57 % (Gewichtsprozent) Wismut, 17 % Zinn, 26 % Indium (Schmelzpunkt 78 °C) oder 48 % Zinn, 52 % Indium (Schmelzpunkt 118 °C).

Ein großer Vorteil der Methode ist außerdem, dass diese Materialien einen homogenen Film ergeben mit einer niedrigen Fehlstellenrate im Gegensatz zu Filmen, die über PVD hergestellt wurden. Herkömmliche Kathoden, die über PVD hergestellt wurden, haben eine hohe Fehlstellenrate, die ein Hauptgrund für die Degradation der OLED über die Zunahme dunkler Stellen ist.

Mit der erfindungsgemäßen Methode zur Herstellung von Kathoden konnten dünne Filme hergestellt werden, die eine Biegsamkeit zeigten, mit denen sie für flexible Anwendungen geeignet sind.

Zur Herstellung eines passiven Matrixdisplays basierend auf lichtemittierenden Polymeren wird zunächst auf einem Glassubstrat nach der bekannten Herstellungstechnik der Schichtaufbau realisiert bis zur Kathode. Dann wird die erste Kathodenschicht, beispielsweise die "injection layer" aus isolierendem Material, abgeschieden in Form eines Pulvers. Danach kann die äußere Kathodenschicht aus "fusible alloys" mit einer Dicke von beispielsweise 200 bis 500 µm aufgedruckt werden. Dieses Herstellungsverfahren ist nicht auf harte Substrate beschränkt, sondern kann durchaus auch auf flexible Substrate angewendet werden.

Dies ist insbesondere in Bezug auf flexible Lichtquellen (flexible light sources) von Bedeutung, wobei zu erwähnen ist, dass Tests ergaben, dass dünne Schichten (< 1 mm) der "fusible alloys" nahezu biegsam sind.

Ebenso können organische Solarzellen oder photovoltaische Zellen, auch auf einem flexiblen Substrat, eine erfindungsgemäße Kathode mit umfassen.

Dies gilt auch für flexible organische Detektoren und integrierte Schaltungen.

Die Kathoden nach der Erfindung können für alle Arten organischer Elektronikbauteile eingesetzt werden.

## Patentansprüche

1. Kathode für ein organisches Elektronikbauteil, die aus einer Schmelze einer metallischen Legierung gefertigt ist, dadurch charakterisiert, dass die Kathode aus 57 Gew% Bi, 17 Gew% Sn, 26 Gew% In oder 48 Gew% Sn, 52 Gew% In besteht.

2. Verfahren zur Herstellung der Kathode des Elektronikbauteils nach Anspruch 1 durch Aufbringen der Schmelze der metallischen Legierung, wobei die Aufbringung durch Stempel- oder Tampondruck, Siebdruck, Hoch- und/oder Tiefdruck, Schablonendruck, Flexodruck, Prägetechnik, Spin Coating, Eintauchen, Rakelverfahren oder wie ein Gießharz erfolgt.

## Claims

1. Cathode for an organic electronic component, which is produced of a melt of a metallic alloy, **characterized in that** the cathode consists of 57 wt% Bi, 17 wt% Sn, 26 wt% In or 48 wt% Sn, 52 wt% In.

2. Method for producing the cathode of the electronic component according to claim 1 by applying the melt of the metallic alloy, wherein the application is carried out by means of a stamp or pad printing, screen printing, high and/or low pressure printing, stencil printing, flexographic printing, embossing technology, spin coating, immersion, doctor blade method or as a casting resin.

## Revendications

1. Cathode pour un composant électronique organique, qui est produit à partir d'une masse fondue d'un alliage métallique, **caractérisée en ce que** la cathode est constituée de 57 % en poids de Bi, 17 % en poids de Sn, 26 % en poids de In ou 48 % en poids de Sn, 52 % en poids de In.

2. Procédé de fabrication de la cathode du composant électronique selon la revendication 1 par application de la masse fondue de l'alliage métallique, l'application est réalisée au moyen par estampage ou tampographie, sérigraphie, impression haute et/ou basse pression, stencil, impression flexographique, technique de gaufrage, revêtement par centrifugation, immersion ou racle ou comme résine à moulage.
